# EUROPÄISCHE PATENTSCHRIFT

(11) **EP 1 053 581 B1**
(45) Veröffentlichungstag und Bekanntmachung des Hinweises auf die Patenterteilung: **19.09.2001**
(21) Anmeldenummer: 98965840.6
(22) Anmeldetag: 16.12.1998
(51) Int. Cl.: H02B 1/56, H05K 7/20

(54) **SCHALTSCHRANK MIT KÜHLVORRICHTUNG**
CONTROL CABINET WITH COOLING DEVICE
ARMOIRE DE COMMANDE AVEC DISPOSITIF DE REFROIDISSEMENT

(30) Priorität: 07.02.1998 DE 19804902
(43) Veröffentlichungstag der Anmeldung: 22.11.2000
(73) Patentinhaber: Rittal-Werk Rudolf Loh GmbH & Co. KG, 35745 Herborn (DE)
(72) Erfinder: NICOLAI, Walter, D-35418 Buseck (DE); PAWLOWSKI, Adam, D-35713 Eschenburg-Wissenbach (DE)
(74) Vertreter: Fleck, Hermann-Josef, Dr.-Ing.
(86) Internationale Anmeldenummer: EP9808234
(87) Internationale Veröffentlichungsnummer: WO9940657

(56) Entgegenhaltungen:
- DE-C- 4 135 894
- US-A- 4 592 602

## Beschreibung

Die Erfindung betrifft einen Schaltschrank mit einem Rahmengestell, das aus Rahmenprofilen zusammengesetzt und mit Seitenteilen und wenigstens einer Schranktür verkleidet ist, und das einen Schaltschrankinnenraum umgibt, in dem elektrische Einbauten untergebracht sind, und wobei im Bereich zumindest einer vertikalen Seite des Rahmengestelles eine Kühlvorrichtung angeordnet ist, die die im Schaltschrankinnenraum entstehende Wärme abführt.

Ein solcher Schaltschrank ist aus der DE 41 11 457 C1 bekannt. Das Rahmengestell des Schaltschrankes ist aus zwölf gleichen Rahmenprofilen zusammengesetzt. Die Seiten des Rahmengestelles sind mit vertikalen Seitenteilen verkleidet. Der Schaltschrank läßt sich mit einem Kühlgerät aufrüsten. Hierzu wird ein Seitenteil vom Rahmengestell abgebaut und an dessen statt das Kühlgerät an den vertikalen Rahmenprofilen angeschraubt. Das Kühlgerät umschließt einen Innenraum, in dem die Kühleinheiten untergebracht sind. In den Innenraum kann Luft aus dem Schaltschrankinnenraum eingesaugt, hier gekühlt und dann wieder in den Schaltschrankinnenraum abgegeben werden.

Es ist Aufgabe der Erfindung, einen Schaltschrank der eingangs erwähnten Art zu schaffen, bei dem die Aufrüstung einer Klimatisierungvorrichtung mit geringem Teileaufwand möglich ist.

Diese Aufgabe der Erfindung wird dadurch gelöst, daß parallel beabstandet zu dem Seitenteil ein Trennelement an den Rahmenprofilen angekoppelt ist, das zusammen mit dem Seitenteil einen Luftführungskanal bildet, und daß das frennelement mit mehreren Durchbrüchen versehen ist, die eine räumliche Verbindung des Luftführungskanals zu dem Schaltschrankinnenraum schaffen, und daß mittels mindestens eines Lüfters Luft durch den Luftführungskanal und wenigstens einen Durchbruch förderbar ist.

Zur Aufrüstung des Schaltschrankes wird das Seitenteil zu einer Komponente der Klimatisierungsvorrichtung, so daß dieses nicht ausgetauscht werden muß. Diese einfache Maßnahme reduziert den konstruktiven Aufwand für eine Kühlvorrichtung erheblich. Darüberhinaus wird die äußere Anmut des Schalt-schrankes, für den Fall, daß das Trennelement im Innenraum des Schaltschrankes angebaut wird, nicht oder nur unwesentlich beeinträchtigt.

Zur vereinfachten Montage kann es vorgesehen sein, daß die, in einer vertikalen Wand des Trennelementes eingebrachten Durchbrüche symmetrisch zu der horizontal und/oder vertikal verlaufenden Mittelquerebene des Trennelementes verteilt angeordnet sind.

Eine bevorzugte Erfindungsausgestaltung sieht vor, daß das Trennelement mit mindestens zwei Reihen von zueinander gleichmäßig beabstandeten Durchbrüchen versehen ist, und daß eine der Reihen im Bodenbereich und die zweite Reihe im Deckelbereich des Innenraumes angeordnet ist. Über die oberen Durchbrüche kann die im Deckelbereich gesammelte, erwärmte Luft abgesaugt, in der Klimatisierungsvorrichtung gekühlt und dann über die Durchbrüche im Bodenbereich wieder in den Schaltschrank eingeleitet werden. Zusätzlich kann es auch vorgesehen sein, daß wenigstens eine weitere Reihe von Durchbrüchen im Mittelbereich zwischen dem Boden- und dem Deckelbereich des Schaltschrankinnenraumes angeordnet ist, um dadurch weitere Zu- oder Ableitungs-möglichkeiten von Luft in bzw. aus dem Luftführungskanal zu schaffen.

Bevorzugterweise ist es vorgesehen, daß die Durchbrüche unabhängig voneinander mittels Abdeckungen verschließbar sind. Dies ermöglicht es dem Anwender, bei einer vorhandenen Klimatisieurungsvorrichtung diejenigen Durchbrüche zu nutzen, die im speziellen Anwendungsfall für eine effektive Kühlung geeignet sind. Die nicht benötigten Durchbrüche werden einfach mit den Abdeckungen verschlossen. Die Abdeckungen können beispielsweise als plattenartige Elemente ausgebildet sein, die mit Haken an dem Trennelement eingehangen und mit einem Befestigungselement an diesem gesichert sind.

Um auf einfache Weise den Lufttransport im Führungskanal zu ermöglichen, ist es erfindungsgemäß vorgesehen, daß im Bereich eines oder mehrerer Durchbrüche Lüfter angebracht sind, die die in dem Führungskanal geförderte Luft durch den Durchbruch hindurch aus dem Schaltschrankinnenraum ansaugen oder in diesen abgeben. Dabei sind die Lüfter vornehmlich an der dem Schaltschrankinnenraum zugewandten Seite des Trennelementes angebracht.

Hierdurch kann das Trennelement dicht an das Seitenteil herangestellt werden, so daß eine raumsparende Bauweise möglich ist.

Die Erfindung wird im folgenden anhand eines in den Zeichnungen dargestellten Ausführungsbeispieles näher erläutert. Es zeigen:
- Fig.1: in perspektivischer Explosionsdarstellung ein Rahmengestell eines Schaltschrankes und ein daran befestigbares Trennelement,
- Fig.2: in Teildarstellung eine an dem Rahmengestell befestigte, als Kühlvorrichtung ausgebildete Klimatisierungseinrichtung und
- Fig.3: die Kühlvorrichtung gem. Fig. 2 jedoch mit einem veränderten Aufbau.

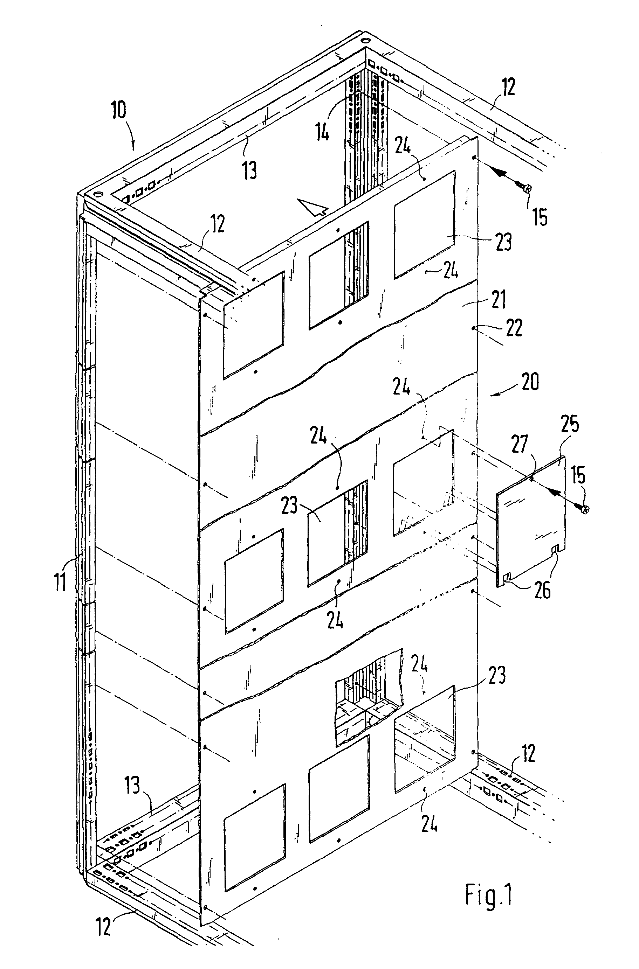

In der Fig. 1 ist ein Rahmengestell 10 dargestellt, das aus vertikalen und horizontalen Rahmenprofilen 11, 12 und 13 zusammengesetzt ist. Die horizontalen Rahmenprofile 12, 13 sind dabei als Tiefen- und Breitenstreben ausgebildet. Sie sind zu einem Boden- und einem Deckrahmen zusammenge-setzt. Der Boden- und der Deckrahmen können miteinander über die vertikalen Rahmenprofile 11 verbunden werden. Die vertikalen Rahmenprofile sind mit vier Profilseiten ausgestattet, die zum Innnenraum des Rahmengestelles 10 gerichtet sind. Diese Profilseiten tragen Reihen von in gleicher Teilung zueinander beab-standeten Befestigungsaufnahmen 14. Jeder Seite des Rahmengestelles 10 sind pro vertikalem Rahmenprofil 11 jeweils zwei Profilseiten zugeordnet, wobei eine der Profilseiten parallel zur zugeordnenten Seite steht. An diesen parallel zur Seite des Rahmengestelles 10 stehenden Profilseiten zweier benachbarter vertikaler Rahmenprofile 11 kann ein Trennelement 20 befestigt werden. Das Trennelement 20 weist im wesentlichen eine vertikale Wand 21 auf, die an ihrer Ober- und Unterseite mit horizontalen Abkantungen versehen ist. In die Wand 21 sind drei Reihen von jeweils drei Durchbrüchen 23 eingebracht. Die quadratischen Durchbrüche sind dabei im oberen, im unteren und im Mittelbereich der Wand 21 angeordnet. Jedem Durchbruch 23 sind zwei Schraubaufnahmen 24 zugeordnet. Die Schraubaufnahmen 24 sind dabei im Bereich gegenüberliegender Seiten der quadratischen Durchbrüche 23 in die Wand 21 eingebracht. Der Fig. 1 kann entnommen werden, daß das Trennelement 20 symmetrisch zur horizontal und vertikal verlaufenden Mittelquerebene der Wand 21 ausgebildet ist. Zur Befestigung des Trennelementes 20 sind im Bereich der vertikalen Seiten der Wand 21 Bohrungen 22 vorgesehen. Die Bohrungen 22 können fluchtend zu Befestigungsaufnahmen 14 der vertikalen Rahmenprofile 11 ausgerichtet werden. Mittels Befestigungselementen 15 läßt sich dann das Trennelement 20 an den vertikalen Rahmenprofilen 11 anschrauben.

Zum Verschließen einer oder mehrerer Durchbrüche 23 sind Abdeckungen 25 verwendet. Die Abdeckungen 25 sind als rechteckige, plattenförmige Elemente ausgebildet. Im Bereich einer Seite sind die Abdeckungen 25 mit ausgestanzten Haken 26 versehen. An der den Haken 26 gegenüberliegenden Seite ist eine Bohrung 27 in die Abdeckung 25 eingebracht. Zum Verschluß eines Durchbruches 23 kann die Abdeckung 25 mit ihren Haken 26 in die Wand 21 eingehangen werden. Anschließend kann ein Befestigungselement 15 durch die Bohrung 27 hindurchgeführt und in die Schraubaufnahme 24 eingeschraubt werden.

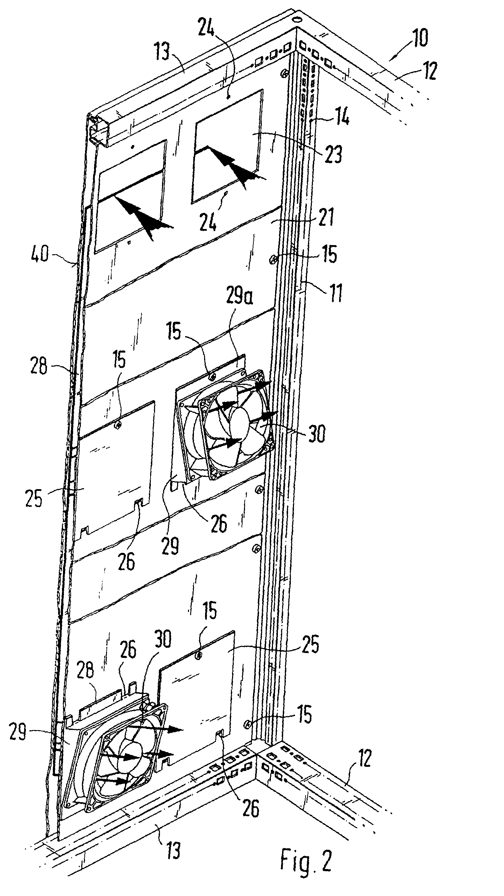

In der Fig. 2 ist ein mögliches Anwendungsbeispiel für die in Fig. 1 gezeigte Kühlvorrichtung dargestellt. Dabei sind die Durchbrüche 23 der unteren und der mittleren Reihe von Durchbrüchen 23 mit Abdeckungen 25 verschlossen. Lediglich einer der Durchbrüche 23 bleibt unverschlossen. Im Bereich dieses unverschlossenen Durchbruches 23 wird ein Lüfter 30 befestigt. Der Lüfter 30 ist auf einem Podest 29 befestigt, das von einer Halterung 29a getragen ist. Die Halterung 29a weist ebenfalls Hakenelemente 26 auf, mit denen sie in die Wand 21 eingehangen und anschließend mittels eines Befestigungselementes 15 in der entsprechenden Schraubaufnahme 24 fixiert werden kann.

Wie der Fig. 2 weiter entnommen werden kann, ist an der Außenseite des Rahmengestelles 10 ein Seitenteil 40 befestigt. Das Seitenteil 40 ist dabei parallel beabstandet zu der Wand 21 des Trennelementes 20 angeordnet. Dadurch bildet sich zwischen dem Seitenteil 40 und dem Trennelement 20 ein Luftführungskanal 28.

Mittels der Lüfter 30 kann die Luft aus dem Luftführungskanal 28 abgesaugt und in den Innenraum des Schaltschrankes eingeblasen werden. Die Durchbrüche 23, die im oberen Bereich der Wand 21 angeordnet sind, schaffen eine räumliche Verbindung zwischen dem Schaltschrankinnenraum und dem Luftführungskanal 28. Über diese Durchbrüche 23 kann somit erwärmte Luft aus dem Schaltschrankinnenraum abgesaugt werden.

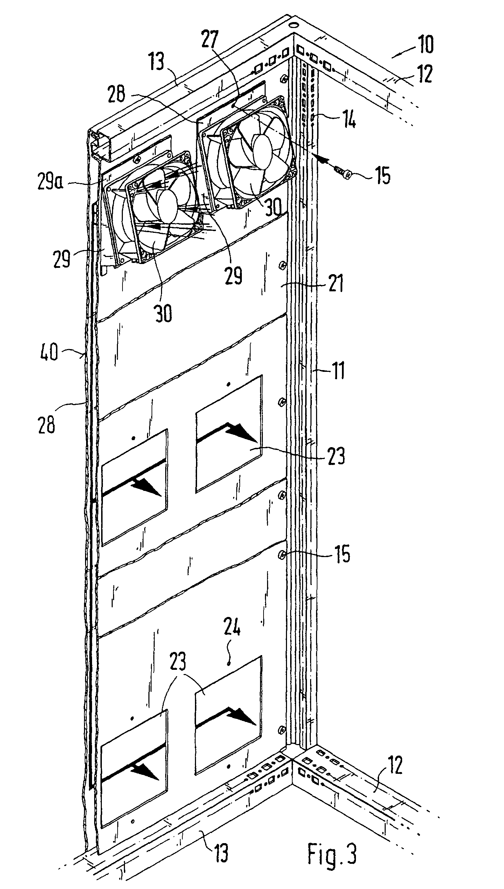

Ein weiteres Anwendungsbeispiel für die erfindungsgemäße Kühlvorrichtung ist in der Fig. 3 veranschlaulicht. Wie aus dieser Darstellung hervorgeht, sind die oben an der Wand 21 angeordneten Durchbrüche 23 jeweils mit einem Lüfter 30 ausgerüstet. Die restlichen Durchbrüche 23 des Trennelementes 20 bleiben unverschlossen. Über die Lüfter 30 kann die erwärmte Luft im Deckelbereich des Schaltschrankes abgesaugt und in den Luftführungskanal 28 eingeblasen werden.

Bei den erfindungsgemäßen Kühlvorrichtungen bildet das Seitenteil 40 einen Wärmetauscher über den die Wärmeenergie der angesaugten Luft an die Umgebung abgegeben werden kann.

Die so gekühlte Luft verläßt dann anschließend durch die offenen Durchbrüche 23 hindurch den Luftführungskanal 28 und gelangt wieder in den Innenraum des Schaltschrankes.

## Patentansprüche

1. Schaltschrank mit einem Rahmengestell (10), das aus Rahmenprofilen (11-13) zusammengesetzt und mit Seitenteilen (40) und wenigstens einer Schranktür verkleidet ist und das einen Schaltschrankinnenraum umgibt, in dem elektrische Einbauten untergebracht sind, und wobei im Bereich zumindest einer vertikalen Seite des Rahmengestelles (10) eine Kühlvorrichtung angeordnet ist, die die im Schaltschrankinnenraum entstehende Wärme abführt,
**dadurch gekennzeichnet**,
daß parallel beabstandet zu dem Seitenteil (40) ein Trennelement (20) an den Rahmenprofilen (11) angekoppelt ist, das zusammen mit dem Seitenteil (40) einen Luftführungskanal (28) bildet,
daß das Trennelement (20) mit mehreren Durchbrüchen (23) versehen ist, die eine räumliche Verbindung des Luftführungskanals (28) zu dem Schaltschrankinnenraum schaffen, und
daß mittels mindestens eines Lüfters (30) Luft durch den Luftführungskanal (28) und wenigstens einen Durchbruch (23) förderbar ist.

2. Schaltschrank nach Anspruch 1,
**dadurch gekennzeichnet,**
**daß** die, in eine vertikalen Wand (21) des Trennelementes (20) eingebrachten Durchbrüche (23) symmetrisch zu der horizontal und/oder vertikal verlaufenden Mittelquerebene des Trennelementes (20) verteilt angeordnet sind.

3. Schaltschrank nach Anspruch 1 oder 2,
**dadurch gekennzeichnet**,
daß das Trennelement (20) mit mindestens zwei Reihen von zueinander gleichmäßig beabstandeten Durchbrüchen (23) versehen ist, und
daß eine der Reihen im Bodenbereich und die zweite Reihe im Deckelbereich des Schaltschrank-Innenraumes angeordnet ist.

4. Schaltschrank nach Anspruch 3,
**dadurch gekennzeichnet,**
**daß** wenigstens eine weitere Reihe von Durchbrüchen (23) im Mittelbereich zwischen dem Boden- und dem Deckelbereich des Schaltschrankinnenraumes angeordnet ist.

5. Schaltschrank nach einem der Ansprüche 1 bis 4,
**dadurch gekennzeichnet,**
**daß** die Durchbrüche (23) unabhängig voneinander mittels Abdeckungen (25) verschließbar sind.

6. Schaltschrank nach Anspruch 5,
**dadurch gekennzeichnet,**
**daß** die Abdeckungen (25) als plattenartige Elemente ausgebildet sind, die mit Haken (26) an dem Trennelement (20) eingehangen und mit einem Befestigungselement (15) an diesem gesichert sind.

7. Schaltschrank nach einem der Ansprüche 1 bis 6,
**dadurch gekennzeichnet,**
**daß** im Bereich eines oder mehrerer Durchbrüche (23) Lüfter (30) angebracht sind, die die in dem Führungskanal geförderte Luft durch den Durchbruch (23) hindurch aus dem Schaltschrankinnenraum ansaugen oder in diesen abgeben.

## Claims

1. Switch cabinet having a framework (10) which is made up of frame profiles (11-13) and is panelled by side parts (40) and at least one cabinet door and encloses a switch-cabinet interior, in which electrical internal components are accommodated, there being arranged, in the region of at least one vertical side of the framework (10), a cooling device which dissipates the heat produced in the switch-cabinet interior, **characterized in that**, at a parallel spacing from the side part (40), a partition element (20) is coupled to the frame profiles (11) and, together with the side part (40), forms an air-channelling duct (28), in that the partition element (20) is provided with a plurality of through-passages (23) which provide a spatial connection between the air-channelling duct (28) and the switch-cabinet interior, and in that air can be conveyed through the air-channelling duct (28) and at least one through-passage (23) by means of at least one fan (30).

2. Switch cabinet according to Claim 1, **characterized in that** the through-passages (23), which are introduced into a vertical wall (21) of the partition element (20), are distributed symmetrically in relation to the horizontally and/or vertically running central transverse plane of the partition element (20).

3. Switch cabinet according to Claim 1 or 2, **characterized in that** the partition element (20) is provided with at least two rows of uniformly spaced-apart through-passages (23), and in that one of the rows is arranged in the base region, and the second row is arranged in the cover region, of the switch-cabinet interior.

4. Switch cabinet according to Claim 3, **characterized in that** at least one further row of through-passages (23) is arranged in the central region between the base region and the cover region of the switch-cabinet interior.

5. Switch cabinet according to one of Claims 1 to 4, **characterized in that** the through-passages (23) can be closed off independently of one another by means of coverings (25).

6. Switch cabinet according to Claim 5, **characterized in that** the coverings (25) are designed as platelike elements which are fitted on the partition element (20) by hooks (26) and are secured thereon by a fastening element (15).

7. Switch cabinet according to one of Claims 1 to 6, **characterized in that** fans (30) are fitted in the region of one or more through-passages (23), the air which is conveyed in the guide duct being taken in from the switch-cabinet interior, or discharged into the same, through the through-passage (23).

## Revendications

1. Armoire de commande avec une baie (10), qui est composée de profilés de cadre (11 - 13) et est habillée de parties latérales (40) et d'au moins une porte d'armoire et qui entoure un espace intérieur d'armoire de commande, dans lequel sont installés des composants électriques, et dans laquelle un dispositif de refroidissement est disposé dans la région d'au moins une face verticale de la baie (10), qui évacue la chaleur dégagée dans l'espace intérieur de l'armoire de commande, **caractérisée en ce qu'**un élément de séparation (20), parallèlement espacé de la partie latérale (40), est couplé aux profilés de cadre (11) et forme avec la partie latérale (40) un canal de guidage d'air (28), en ce que l'élément de séparation (20) est pourvu de plusieurs ouvertures (23), qui créent une communication spatiale du canal de guidage d'air (28) avec l'espace intérieur de l'armoire de commande, et en ce que de l'air peut être transporté au moyen d'au moins un ventilateur (30) à travers le canal de guidage d'air (28) et au moins une ouverture (23).

2. Armoire de commande suivant la revendication 1, **caractérisée en ce que** les ouvertures (23) pratiquées dans une paroi verticale (21) de l'élément de séparation (20) sont réparties symétriquement par rapport au plan transversal médian, horizontal et/ou vertical, de l'élément de séparation (20).

3. Armoire de commande suivant la revendication 1 ou 2, **caractérisée en ce que** l'élément de séparation (20) est pourvu d'au moins deux rangées d'ouvertures (23) uniformément espacées l'une de l'autre, et en ce qu'une des rangées est disposée dans la région du bas et la deuxième rangée est disposée dans la région du haut de l'espace intérieur de l'armoire de commande.

4. Armoire de commande suivant la revendication 3, **caractérisée en ce qu'**au moins une autre rangée d'ouvertures (23) est disposée dans la région centrale entre la région du bas et la région du haut de l'espace intérieur de l'armoire de commande.

5. Armoire de commande suivant l'une quelconque des revendications 1 à 4, **caractérisée en ce que** les ouvertures (23) peuvent être obturées au moyen de couvercles (25) indépendamment les unes des autres.

6. Armoire de commande suivant la revendication 5, **caractérisée en ce que** les couvercles (25) ont la forme d'éléments en forme de plaque, qui sont suspendus par des crochets (26) à l'élément de séparation (20) et qui sont fixés à celui-ci avec un élément de fixation (15).

7. Armoire de commande suivant l'une quelconque des revendications 1 à 6, **caractérisée en ce que**, dans la région d'une ou de plusieurs ouvertures (23), sont installés des ventilateurs (30) qui aspirent hors de l'espace intérieur de l'armoire de commande, ou qui envoient dans celui-ci, à travers l'ouverture (23), l'air transporté dans le canal de guidage.
